# EUROPÄISCHE PATENTSCHRIFT

(11) **EP 1 241 484 B1**
(45) Veröffentlichungstag und Bekanntmachung des Hinweises auf die Patenterteilung: **05.10.2005**
(21) Anmeldenummer: 02003941.8
(22) Anmeldetag: 22.02.2002
(51) Int. Cl.: G01R 33/561

(54) **Verfahren zur Messung der Magnetresonanz (NMR) mittels SSFP**
SSFP NMR method
Procédé de mesurer la résonance magnétique (RMN) au moyen de SSFP

(30) Priorität: 16.03.2001 DE 10112704
(43) Veröffentlichungstag der Anmeldung: 18.09.2002
(73) Patentinhaber: Universitätsklinikum Freiburg, 79106 Freiburg (DE)
(72) Erfinder: Hennig, Jürgen, 79100 Freiburg (DE)
(74) Vertreter: Kohler Schmid Möbus

(56) Entgegenhaltungen:
- DE-A- 4 427 497
- DE-A- 19 630 758
- HENNIG J ET AL: "Optimization of signal behavior in the transition to driven equilibrium in steady-state free precession sequences" MAGNETIC RESONANCE IN MEDICINE, NOV. 2002, WILEY, USA, Bd. 48, Nr. 5, Seiten 801-809, XP002266990 ISSN: 0740-3194
- J.HENNIG ET AL.: "Optimization of steady state free precession sequences by continuous transition into driven equilibrium (TIDE)" ISMRM TENTH SCIENTIFIC MEETING, HONOLULU, HAWAI'I, USA, 18-24 MAY 2002, Seite 378 XP002266991
- D.G.NISHIMURA ET AL.: "Analysis and Reduction of the Transient Response in SSFP Imaging" ISMRM EIGHTH SCIENTIFIC MEETING, DENVER, COLORADO, USA, 1-7 APRIL 2000, Seite 301 XP002266992
- WILLIAMS C F M ET AL: "SOURCES OF ARTIFACT AND SYSTEMATIC ERROR IN QUANTITATIVE SNAPSHOT FLASH IMAGING AND METHODS FOR THEIR ELIMINATION" MAGNETIC RESONANCE IN MEDICINE, ACADEMIC PRESS, DULUTH, MN, US, Bd. 41, Nr. 1, 1999, Seiten 63-71, XP000799741 ISSN: 0740-3194

## Beschreibung

Die Erfindung betrifft ein Verfahren der NMR(= Kernspinresonanz)-Tomographie zur Erzeugung von NMR- Gradientenecho-Signalen nach dem Prinzip der Signalerzeugung der Steady State Free Precession (SFP), bei welchem eine periodische Folge von Hochfrequenzimpulsen mit Flipwinkel α im zeitlichen Abstand TR angewendet wird, wobei jeweils aufeinander folgende Hochfrequenzimpulse alternierende Phasen aufweisen.

Die Erzeugung eines SFP-Signals erfolgt durch eine kontinuierliche Folge von Hochfrequenzimpulsen und wurde von Carr bereits 1958 eingeführt (Phys.Rev.112,1693(1958)).Carr konnte zeigen, dass eine Implementierung des Verfahrens mit äquidistanten Hochfrequenzimpulsen mit konstanter Amplitude und alternierender Phase zu einer besonders hohen Signalintensität des SFP-Signals von on-resonance Spins führt.

Dieses Prinzip wurde 1986 in Form des FISP-Verfahrens (inzwischen true FISP genannt) in ein Verfahren der MR-Bildgebung umgesetzt (A.Oppelt et al. electromedica 54, 15 (1986)). Alle Gradienten sind so geschaltet, dass deren Integral vom Zentrum eines Pulses bis zum Zentrum des nächsten Pulses gleich Null ist. Aufeinanderfolgende Pulse haben Flipwinkel α und alternierende Phasen: P1, P3, P5 ...= α, P2, P4, P6 ..= -α. Der zeitliche Abstand zwischen 2 Pulsen wird als Wiederholzeit TR bezeichnet.

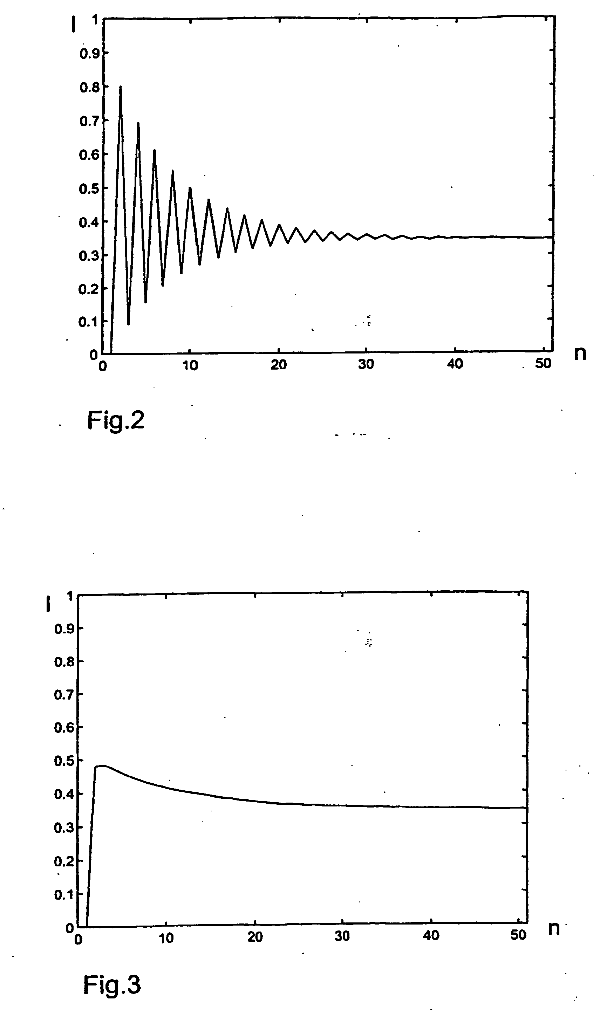

Ein Problem bei der Implementierung stellt dabei die Tatsache dar, dass der Übergang in den sich ergebenden Signal-Gleichgewichtszustand erst allmählich innerhalb einer durch die T1-Relaxation bestimmten Zeit vonstatten geht. Bis zur Erreichung dieses Gleichgewichtszustands treten periodische Signalfluktuationen auf, welche bei Verwendung der Sequenz für die MRT zu starken Bildartefakten führen (siehe Fig.2).

Eine Unterdrückung dieser initialen Signalfluktuationen gelingt dadurch, dass vor der kontinuierlichen Folge von Hochfrequenzimpulsen ein einzelner Puls mit Flipwinkei α/2 im zeitlichen Abstand von TR/2 angewendet wird (Deimling, M. DE 44 27 497 A1). Hierdurch werden die initialen Signalmodulationen unterdrückt und es findet lediglich eine monotone Signaländerung in den Gleichgewichtszustand statt (Fig.3).

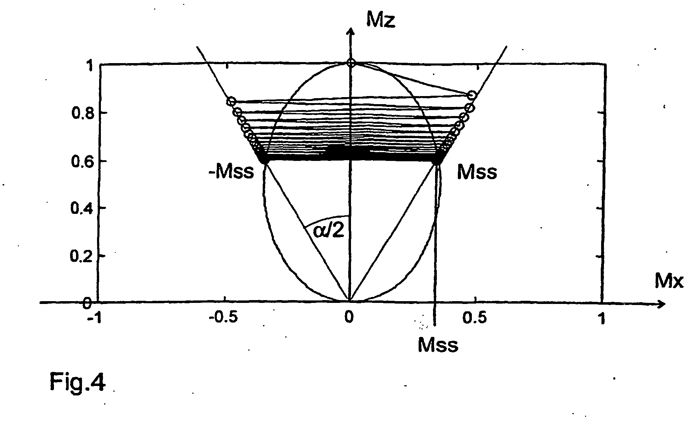

Eine Erklärung der Unterdrückung der Signalmodulation folgt aus einer Betrachtung der aufeinanderfolgenden Signale entsprechend Fig.4, wobei die Hochfrequenzimpulse jeweils mit einem Hochfrequenzfeld mit einer Phase parallel zur y-Achse der transversalen Ebene angewendet werden. Das Diagramm der transversalen Magnetisierung Mx vs. Mz zeigt dann, dass der Magnetisierungsvektor der Gleichgewichtszustands-Magnetisierung Mss gegenüber der z-Achse um einen Winkel α/2 gekippt ist, so dass Mss von aufeinanderfolgenden Hochfrequenzimpulsen jeweils zwischen +-Mss hin- und hergeflipt wird. Durch die Initialisierung mit α/2 wird die ursprüngliche z-Magnetisierung M0 bereits in die richtige Kippung gebracht und in aufeinanderfolgenden Hochfrequenzimpulsen wird dann lediglich der Magnetisierungsvektor entsprechend der T1- und T2-Relaxation in Mss überführt, wobei die Signale (=Betrag der x-Komponente Mss(x) von Mss) Symmetrie keine Modulation aufweisen.

Allerdings gilt dies nur für sogenannte on-resonance Spins, welche während TR keinerlei Phasenänderung erfahren. Bei Anwendungen in der MR-Tomographie (=MRT) ist diese Bedingung allerdings selbst für sehr kleine Wiederholzeiten TR nicht erfüllt, wobei TR im wesentlichen durch die Schaltgeschwindigkeiten der Magnetfeldgradienten bestimmt wird.

Durch Magnetfeldinhomogenitäten erfahren Spins eine gewisse Dephasierung um einen Phasenwinkel Δφ zwischen zwei Anregungen. Für TR=4 ms ist z.B. Δφ =90° für eine off-resonance Frequenz ΔΩ von Δφ /(TR* 360°)= 66 Hz. Dies entspricht bei einer Resonanzfrequenz von 63 MHz bei 1,5 Tesla Feldstärke einer Inhomogenität von 1 ppm. Solche Inhomogenitäten sind bei Anwendungen am Menschen wegen der dort auftretenden Suszeptibilitätseffekte nicht vermeidbar.

Fig.5 zeigt die Signalentwicklung in einem nach DE 44 27 497 A1 optimierten Verfahren als Funktion von Δφ. Es ist unverkennbar, dass Spins mit ΔΩ ungleich 0 über die ersten Anregungsperioden eine Modulation erleiden.

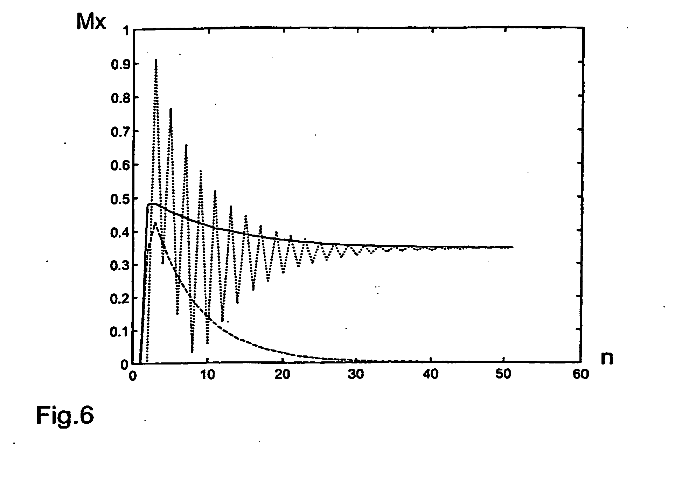

Die entsprechenden Signalintensitäten für Δφ=0°, 180° und 360° sind in Fig.6 gezeigt. Die Modulationen gehen nur sehr langsam in die für Δφ charakteristische Gleichgewichtszustands-Amplitude über. Diese Modulationen führen zu Bildartefakten. Die Unterschiede im Verhalten der Spins, welche durch Δφ=0° und Δφ=360° charakterisiert sind erklären sich dadurch, dass diese Spins enrtsprechend dem Verfahren nach DE 44 27 497 A1 in der initialen Periode TR/2 um 180° gegeneinander dephasiert werden.

Eine weitere unvorteilhafte Eigenschaft des Verfahrens nach DE 44 27 497 A1 liegt darin, dass durch die Anwendung des kleinen Flipwinkels α/2 zur Initialisierung der Gleichgewichtszustands-Sequenz nur ein relativ kleiner Teil der ursprünglich vorhandene Magnetisierung M0 entsprechend M0 sin(α/2) der Auslesung zugänglich gemacht werden.

Aufgabe der vorliegenden Erfindung ist es demgegenüber, ein Verfahren der eingangs beschriebenen Art so zu verbessern, dass die oben diskutierten Nachteile vermieden werden können.

Erfindungsgemäß wird diese Aufgabe auf wirkungsvolle Art und Weise durch die Merkmale der Anspruche 1 oder 3 gelöst.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

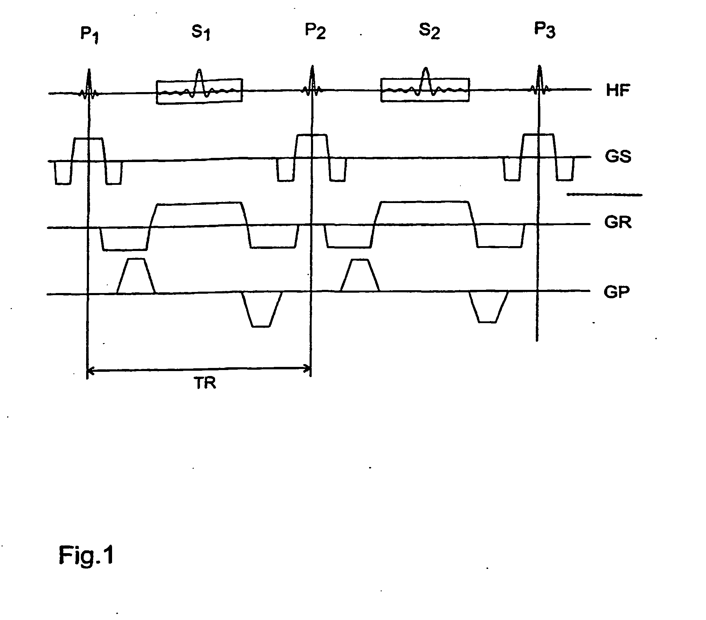

- Fig.1: ein Schema einer trueFISP-Sequenz, wobei HF, GS, GR und GP die Hochfrequenzpulse P1, P2, P3 und Signale S1, S2 bezeichnen, GS den Schichtselektionsgradient, GR den Lesegradient und GP den Phasenkodiergradient;
- Fig.2: die Intensitäten I der Signale S_{1..n} als Funktion von n, wobei für die Simulationsrechnungen folgende Parameter gewählt wurden: TR=4 ms, T1=50 ms, T2=25 ms, α=60°;
- Fig.3: wie Fig.2, jedoch mit einem initialen Pulse mit Flipwinkel 30°, welcher 2 ms vor der Sequenz angewendet wird;
- Fig.4: die Lage der Magnetisierungsvektoren M in der x-z-Ebene bei Anwendung von HF-Pulsen, deren B1-Feld entlang der y-Achse ausgerichtet ist (senkrecht zur Bildebene) bei Anwendung des Verfahrens nach DE 44 27 497 A1; wobei die Ellipse den signal steady state kennzeichnet für die gewählten Parameter von T1=50 ms und T2=25 ms als Funktion von α, und wobei der steady state für ein bestimmtes α (hier: α =60°) gerade dem Schnittpunkt der Ellipse mit einer um +- α/2 gegenüber der z-Achse geneigten Gerade entspricht;

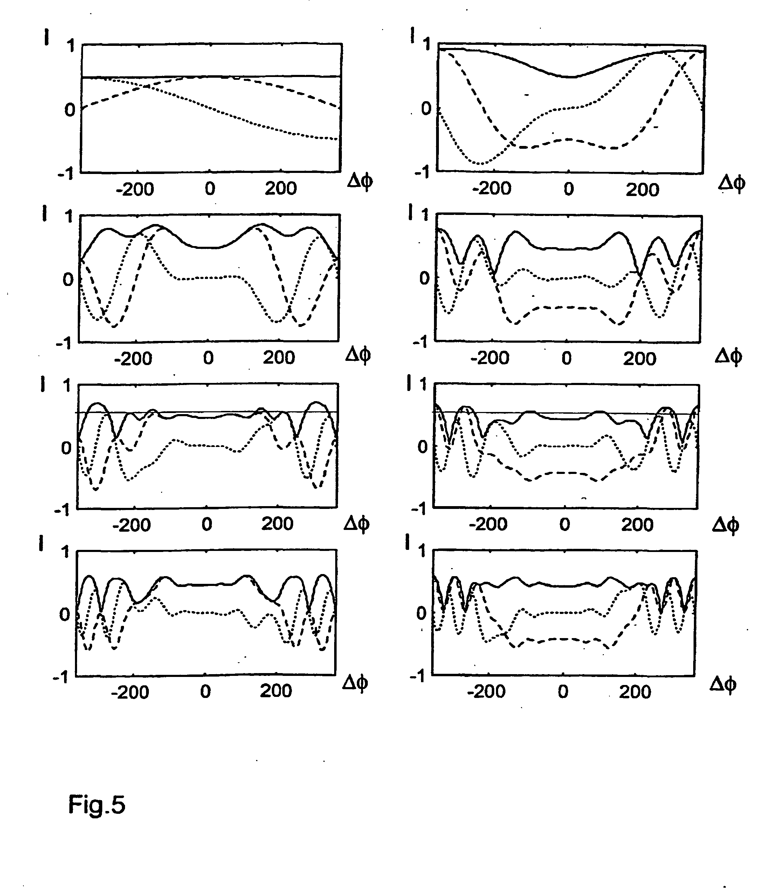

- Fig.5: die x-(gestrichelt) und y-(gepunktet) Magnetisierung sowie die Signalintensität I (durchgezogene Linie) als Funktion der Dephasierung Δφ (in Grad) während TR über die ersten 8 Signale. I entspricht dem Betrag der transversalen Magnetisierung. Das B1-Feld der Anregungspulse ist entlang y ausgerichtet.
- Fig.6: Mx als Funktion von n für Δφ= 0°(durchgezogene Linie, entspricht Fig.3), 180° (gestrichelt) und 360° (gepunktet);
- Fig.7: die Lage der Magnetisierungsvektoren M in der x-z-Ebene bei Anwendung von HF-Pulsen, deren B1-Feld entlang der y-Achse ausgerichtet ist (senkrecht zur Bildebene) mit Flipwinkeln α₀=90°,α_{1..n}= - 160°, 140°, -120°, 100°, -80°, 60°, -60°, 60°....;
- Fig.8: Mx als Funktion von n für Δφ= 0°(durchgezogene Linie), 180° (gestrichelt) und 360° (gepunktet) für eine Sequenz nach Fig.7;
- Fig.9: die Lage der Magnetisierungsvektoren M in der x-z-Ebene bei Anwendung von HF-Pulsen, deren B1-Feld entlang der y-Achse ausgerichtet ist (senkrecht zur Bildebene) mit Flipwinkeln, welche in 5°- Schritten gegen α=60° gehen: α₀=90°,α_{1...n}=-175°, 170°, -165°, 160°, -155°,....,70°, -65°, 60°, -60°, 60°....;
- Fig.10: Mx als Funktion von n für Δφ= 0°(durchgezogene Linie), 180° (gestrichelt) und 360° (gepunktet) für eine Sequenz nach Fig.9;
- Fig.11: die Lage der Magnetisierungsvektoren M in der x-z-Ebene bei Anwendung von HF-Pulsen, deren B1-Feld entlang der y-Achse ausgerichtet ist (senkrecht zur Bildebene) mit Flipwinkeln α₀=90°,α_{1..n}=- 180°, 180°, -120°, 60°, -60°, 60°....;
- Fig.12: Mx als Funktion von n für Δφ= 0°(durchgezogene Linie), 180°(gestrichelt) und 360° (gepunktet) für eine Sequenz nach Fig.11;
- Fig.13: Mx als Funktion von n für Δφ= 0°(durchgezogene Linie), 180° (gestrichelt) und 360° (gepunktet) für eine Sequenz mit . α₀=90°,α_{1.20}= +-180°, α₂₁=120° und α_{22...50}= +-60°;
- Fig.14: die Lage der Magnetisierungsvektoren M in der x-z-Ebene bei Anwendung von HF-Pulsen, deren B1-Feld entlang der y-Achse ausgerichtet ist (senkrecht zur Bildebene) mit Flipwinkeln α₀=90°, α₁₋₁₂= α_{13..24} = ... = -180, 120, -60, 60, -60, 60, -60, 60, -60, 60, -60, 120;
- Fig.15: Mx als Funktion von n für Δφ= 0°(durchgezogene Linie, entspricht Fig.3), 180° (gestrichelt) und 360° (gepunktet) für eine Sequenz nach Fig.14.

Das erfindungsgemäße Verfahren bezieht sich auf die Erzeugung von NMR-Signalen nach dem Prinzip der Signalerzeugung im Driven Equilibrium (DE)- oder auch Steady State Free Precession (SFP). Gegenüber dem Stand der Technik gelingt es mit dem erfindungsgemäßen Verfahren, den Übergang vom Gleichgewichtszustand in das DE nach wenigen Anregungsperioden zu bewerkstelligen und zwar so, dass fluktuierende Signale von off-resonance Spins weitestgehend vermieden werden und zudem im Übergang zum DE Signale mit einer höheren Amplitude erzeugt werden als es dem DE entspricht, welche insbesondere bei Anwendung des Verfahrens in der MRT zur Optimierung der Bildqualität und des -kontrastes Verwendung finden können.

Beim erfindungsgemäßen Verfahren werden einer steady state-(=Gleichgewichtszustands)-Sequenz mit Flipwinkeln α und alternierender Phase n+1 Pulse mit unterschiedlichen Flipwinkeln α_{0...n} vorangestellt, wobei in der bevorzugten Implementierung folgende Merkmale erfüllt werden:
- Die Initialisierung der Sequenz erfolgt mit einem Hochfrequenzimpuls mit einem Flipwinkel α₀ > α/2. Im allgemeinen wird α₀ = 90° gesetzt. Dieser Hochfrequenzimpuls wird analog zu dem in der DE 44 27 497 A1 beschriebenen Verfahren bevorzugt in einem zeitlichen Abstand von TR/2 der Sequenz vorangestellt werden.
- Alle α_{1...n} sind größer als α und werden so gewählt, dass die zum Auslesezeitpunkt jeweils gebildete transversale Magnetisierung Mtr_{1..n} symmetrisch oder zumindest nahezu symmetrisch in Bezug auf die z-Achse zu der zum jeweils vorangehenden Auslesezeitpunkt gebildeten Magnetisierung ist, wobei sich diese Symmetric bis in die periodische Folge von Hochfrequenz impulsen hinein fortsetzt. Nach einer Initialisierung mit einem 90°-Puls wird α₁ also auf 180° oder zumindest nahe 180° gesetzt, die Flipwinkel α₁ bis αₙ der nachfolgenden Hochfrequenzimpulse fallen dann im Wesentlichen monoton auf α ab, wobei deren Phase alterniert.

Die genaue Wahl.von α_{1...n} hängt dabei von den erwünschten Signalintensitäten ab, so dass es im Rahmen der angegebenen Bedingungen eine Vielzahl von möglichen und sinnvollen Werten für α_{1...n} ergibt.

In einer besonders einfachen und deshalb häufig bevorzugten Implementierung kann linear zwischen α₁=180° und αₙ = α variiert werden, wobei n ein noch frei wählbarer Parameter ist.

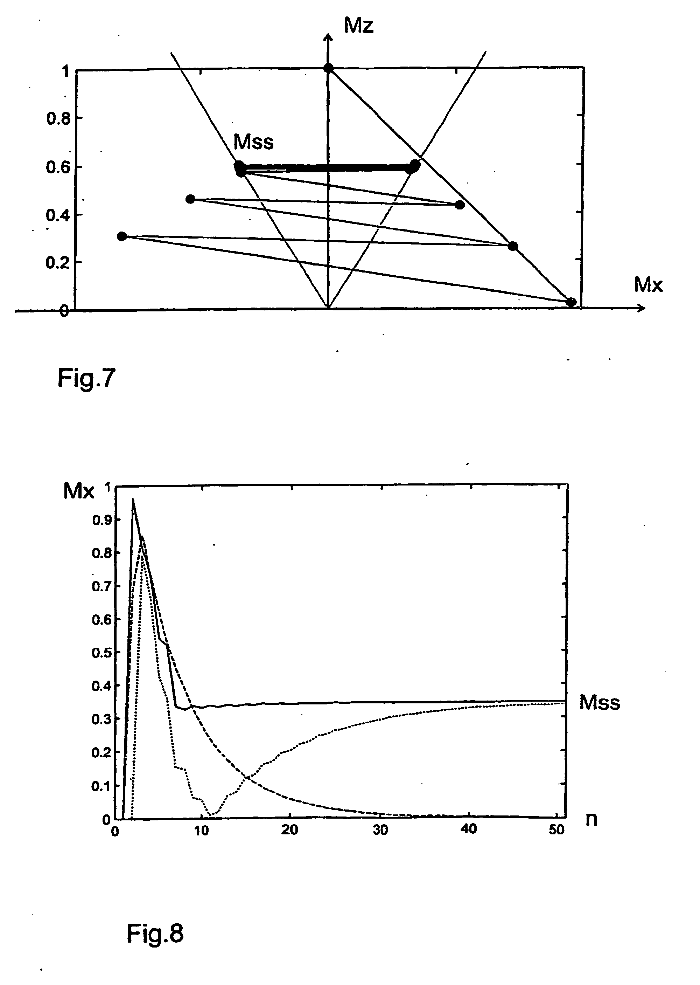

In Fig.7 wird der Vorteil dieser Implementierung im Vergleich mit der herkömmlichen Implementierung deutlich: Zum einen wird Mss in wenigen Schritten erreicht, wobei die Signalamplituden in den ersten n Anregungsschritten deutlich über denjenigen der herkömmlichen Implementierung liegen.

Fig.8 zeigt dass hierbei auch die Modulationen der off-resonance Spins drastisch reduziert werden, so dass die bei Verwendung dieser Signale in der bisherigen Art auftretenden Bildartefakte sehr stark vermindert werden.

Qualitativ lässt sich dieses besonders günstige off-resonance Verhalten so erklären, dass bei Flipwinkeln in der Nähe von 180° der Spin-echo Charakter der Signale zunimmt, welcher sich bekanntermaßen durch ein besonders günstiges Verhalten gegenüber off-resonance-Spins auszeichnet.

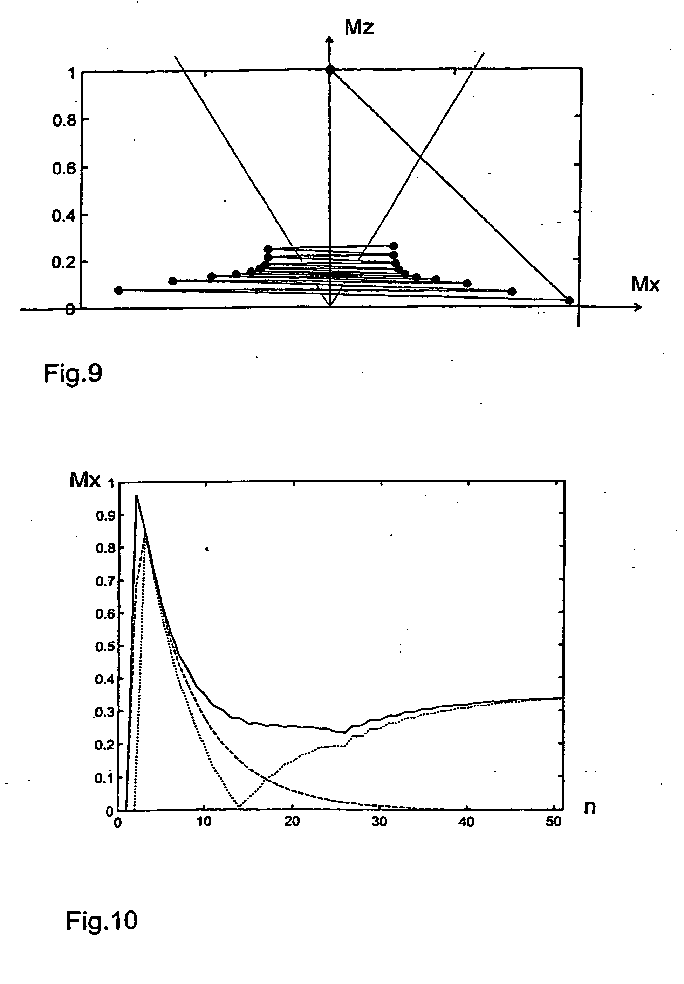

Fig.9 und 10 zeigen, dass bei einem langsameren Übergang der Flipwinkel, deren Betrag hier nur um 5° verändert wird, das Slgnalverhalten weiter verbessert wird und die Signalintensitäten monoton gegen Mss gehen.

Eine quantitative Analyse des Signalverhaltens ist anhand von numerischen Lösungen der Bloch'schen Gleichungen ohne weiteres möglich. Der Fachmann kann sich aus einer solchen Behandlung entsprechende Flipwinkel für andere geeignete Implementierungen ohne weiteres berechnen.

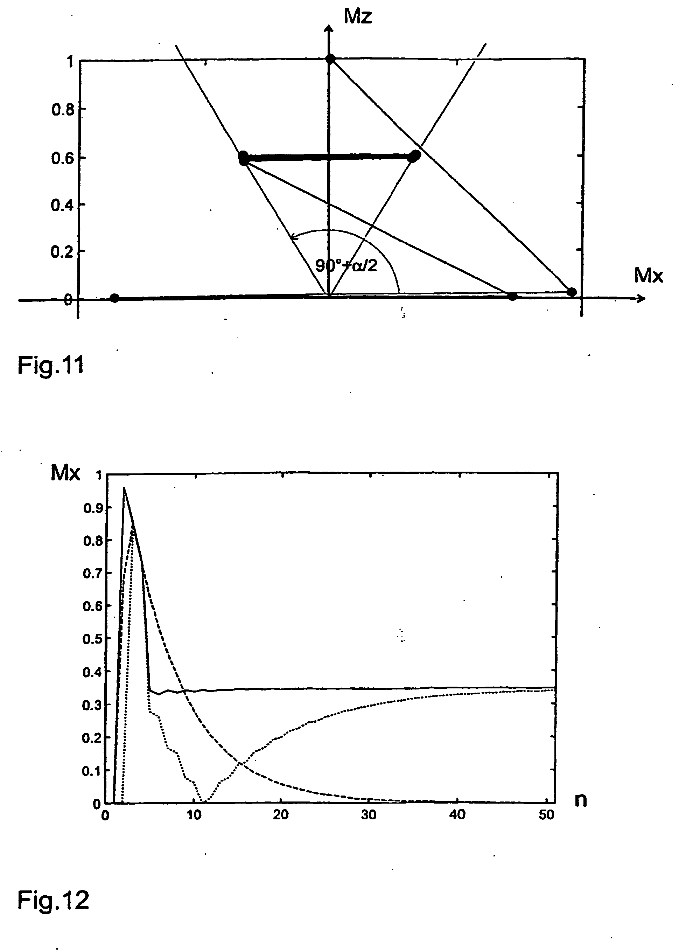

Ein zweiter und oft vorteilhafter Ansatz zur Wahl von α_{1...n} besteht darin, die Flipwinkel α_{1...n-1} nach Vorbereitung durch einen 90°-Impuls auf exakt oder annähernd 180° zu setzen. Wichtig ist es dabei, den n-ten Hochfrequenzimpuls auf 90°+α/2 zu setzen, um die nach jeweils α_{1...n} als reine transversale Magnetisierung vorliegenden Spins wiederum in die für Mss gültige Ebene zu überführen (Fig.11).

Die für eine gegebene Anwendung günstige Wahl von n hängt dabei vor allem von der Relaxationszeit T2 ab. Fig.12 zeigt für die gewählten Werte von T1=50 ms, T2=25 ms die Intensitäten für die in Fig.11 gezeigte Pulsfolge.

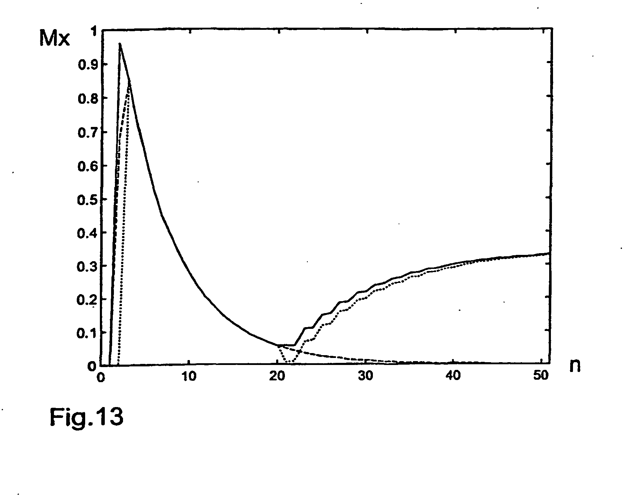

Selbst für n=1, also eine Initialisierung mit einer 90°, 90°+α/2-Folge wird ein gegenüber der herkömmlichen Sequenz vorteilhaftes off-resonance Verhalten erreicht. Wird n so gewählt, dass n*TR >= T2 wird, so zerfällt das Signal gegen Null und erholt sich bei der anschließenden alternierenden Pulsfolge mit α nur langsam mitT1 gegen Mss (Fig.13). Für Gewebe mitT1>>T2 lassen sich auf diese Weise Signale mit kurzem T2 sehr effizient unterdrücken.

Durch entsprechende Wahl von n lässt sich so der T2-Kontrast der Signale und damit bei entsprechender Wahl der Phasenkodierung der entsprechenden Bilder variieren: Eine lange Folge initialer 180°-Pulse führt zu einem starken T2-Kontrast, während bei nur wenigen initialen 180°-Pulsen ein weniger ausgeprägter T2-Kontrast ausgebildet wird.

Schliesslich sollte noch erwähnt werden, dass sich die Magnetisierung, welche sich in oder nahe dem steady state Mss befindet, durch einen Hochfrequenzimpuls mit Flipwinkel 90+α/2 wieder in reine transversale Magnetisierung überführen lässt, um dann durch eine nachfolgende Folge von Hochfrequenzimpulsen, welche wiederum den oben angegebenen Verfahrens typischen Kriterien genügen, wieder in den steady state überführt zu werden.

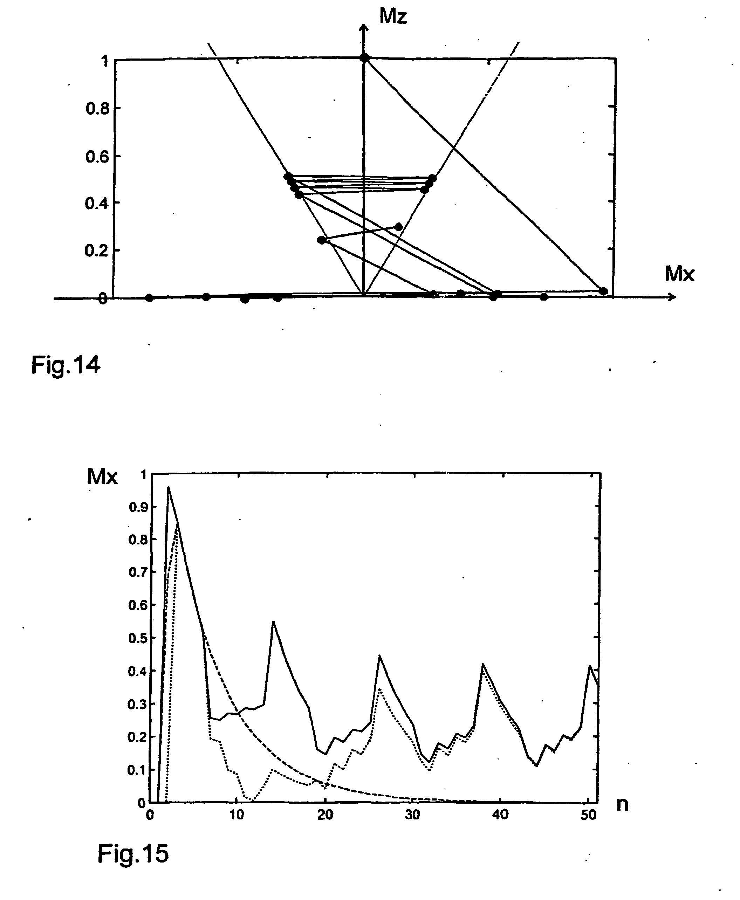

Eine solche Wiederholung von mehreren Perioden reiner 180° Pulse mit alternierender Phase ist in Fig.14 gezeigt. Fig.15 zeigt die entsprechenden Magnetisierungen.

Das Verfahren lässt sich auch mit den in DE 44 27 497 A1 aufgezeigten zusätzlichen Kontrastmodifikationen durch entsprechende Präparationspulse oder -pulsfolgen kombinieren. Die Phasenkodierung kann dabei neben der häufig angewendeten zwei-dimensionalen Fouriertransformation auch in einem drei-dimensionalen Phasenkoderverfahren erfolgen.

Mehrschichtaufnahmen durch sequentielle Anregung paralleler Schichten sind ebenfalls möglich und können zur Erzielung von Bildern entsprechenden Kontrastes ohne weiteres und in einer dem Fachmann unmittelbar zugänglichen Art und Weise realisiert werden.

In den Rahmen der vorliegenden Erfindung fällt auch eine sinngemäße Übertragung des Verfahrens auf Verfahren, bei welchen eine Bildkodierung nach anderen Methoden wie etwa der gefilterten Rückprojektion (Backprojection) erfolgt.

## Patentansprüche

1. Verfahren der NMR(= Kernspinresonanz)- Tomographie zur Erzeugung von NMR-Gradientenecho-Signalen nach dem Prinzip der Signalerzeugung der Steady State Free Precession, bei welchem eine periodische Folge von Hochfrequenzimpulsen mit Flipwinkel α im zeitlichen Abstand TR angewendet wird, wobei jeweils aufeinander folgende Hochfrequenzimpulse alternierende Phasen aufweisen,
**dadurch gekennzeichnet,**
**dass** zu dem Zweck, dass fluktuierende Signale von off-resonance Spins weitestgehend vermieden und zudem im Übergang zur Steady State Free Pecession Signale mit einer höheren Signalamplitude als in der Steady State Free Precession selbst erzeugt werden, der periodischen Folge von Hochfrequenzimpulsen eine Folge von (n+1), mit n>1, Hochfrequenzimpulsen vorangestellt wird, die Signale erzeugen, die jeweils zu einem Auslesezeitpunkt auslesbar sind, wobei für die Hochfrequenzimpulse folgende Bedingungen gelten:
- ein erster Anregungsimpuls mit Flipwinkel αₒ > α/2 wird der im weiteren äquidistanten Folge der Hochfrequenzimpulse vorangestellt;
- die Flipwinkel α₁ bis αₙ₋₁ der folgenden Hochfrequenzimpulse sind grösser als α und werden so gewählt, dass die zum Auslesezeitpunkt jeweils gebildete transversale Magnetisierung Mtr_{1...n} zumindest nahezu symmetrisch in bezug auf die z-Achse zu der zum jeweils vorangehenden Auslesezeitpunkt gebildeten Magnetisierung ist, wobei sich diese Symmetrie bis in die periodische Folge von Hochfrequenzimpulsen hinein fortsetzt;
- die Flipwinkel α₁ bis αₙ fallen im wesentlichen monoton auf α ab;
- die Phasen der vorangestellten Hochfrequenzimpulse alternieren.

2. Verfahren nach Anspruch 1, **dadurch gekennzeichnet, dass** bei alternierender Phase die Flipwinkel *α*_{1...n} der Hochfrequenzimpulse linear von 180° nach α abfallen.

3. Verfahren nach einem der Ansprüch 1 oder 2, **dadurch gekennzeichnet**, dans α₀=90°.

4. Verfahren der NMR(=Kernspinresonanz)-Tomographie zur Erzeugung von NMR-Gradientenecho-Signalen nach dem Prinzip der Signalerzeugung der Steady State Free Precession, bei welchem eine periodische Folge von Hochfrequenzimpulsen mit Flipwinkel α<180° im zeitlichen Abstand TR angewendet wird, wobei jeweils aufeinander folgende Hochfrequenzimpulse alternierende Phasen aufweisen,
**dadurch gekennzeichnet,**
**dass** zu dem Zweck, dass fluktuierende Signale von off-resonance Spins weitestgehend vermieden und zudem im Übergang zur Steady State Free Pecession Signale mit einer höheren Signalamplitude als in der Steady State Free Precession selbst erzeugt werden, der periodischen Folge von Hochfrequenzimpulsen eine Folge von (n+1), mit n≥1, Hochfrequenzimpulsen vorangestellt wird, für die folgende Bedingungen gelten:
- ein erster Anregungsimpuls mit Flipwinkel 90° wird der im weiteren äquidistanten Folge der Hochfrequenzimpulse vorangestellt;
- nachfolgend werden n-1 Hochfrequenzimpulse mit Flipwinkel 180° angewendet;
- der Flipwinkel des (n+1)-ten Hochfrequenzimpulses wird auf αₙ₊₁ = 90° + α/2 gesetzt;
- die Phasen der vorangestellten Hochfrequenzimpulse alternieren.

5. Verfahren nach einem der vorhergehenden Ansprüche, **dadurch gekennzeichnet, dass** der zeitliche Abstand zwischen dem ersten Ausgungsignals und der in weiteren äquidistenden Polye der Hochfrequenzimpulse TR/2.

6. Verfahren nach einen der vorhergehende Ansprüche, **dadurch gekennzeichnet, dass** zusätzlich zu der Folge von Hochfrequenzimpulsen Magnetfeldgradienten zur Kodierung eines MR-Bildes entsprechend einem zwei- oder auch mehrdimensionalen Fourier-Transformverfahren angewendet werden und zwar so,
- dass durch Anwendung eines Schichtselektionsgradienten während der Hochfrequenzimpulse eine Schicht selektiert wird,
- dass durch Anwendung eines Lesegradienten, welcher im Sinne eines Gradientenechoverfahrens zunächst eingeschaltet wird und dann in seiner Amplitude umgekehrt wird, ein Gradientenecho gebildet wird,
- dass vor Auslesen des Gradientenechos eine Phasenkodierung erfolgt.

7. Verfahren nach Anspruch 6, **dadurch gekennzeichnet, dass** eine Phasenkodierung durch Anwendung eines Phasenkodiergradienten senkrecht zum Lesegradienten im Sinne eines zwei-dimensionalen Fourier-Transformverfahrens erfolgt.

8. Verfahren nach Anspruch 6, **dadurch gekennzeichnet, dass** eine Phasenkodierung durch Anwendung mehrerer Phasenkodiergradienten in senkrecht aufeinander stehenden Richtungen zur Phasenkodierung im Sinne eines mehr-dimensionalen Fourier-Transformverfahrens erfolgt.

9. Verfahren nach einem der vorhergehenden Ansprüche, **dadurch gekennzeichnet, dass** der Sequenz eine Spinpräparation durch einen Inversionspuls zur Signalgewichtung mit T1 vorangestellt wird.

10. Verfahren nach einem der vorhergehenden Ansprüche, **dadurch gekennzeichnet, dass** eine Anwendung von Magnetfeldgradienten entsprechend einer Bildkodierung nach dem Verfahren der gefilterten Rückprojektion erfolgt.

11. Verfahren nach einem der vorhergehenden Ansprüche, **dadurch gekennzeichnet, dass** nach k Hochfrequenzimpulsen mit k>n zunächst ein Hochfrequenzimpuls mit Flipwinkel 90°+α/2 angewendet wird, so dass die gebildeten Magnetisierung im oder nahe dem Gleichgewichtszustand (=steady state) in transversale Magnetisierung überführt wird und anschließend durch Wiederholung der Folge von Hochfrequenzimpulsen erneut in den Gleichgewichtszustand überführt werden.

12. Verfahren nach Anspruch 11, **dadurch gekennzeichnet, dass** die Rückführung der Magnetisierung in transversale Magnetisierung mehrfach wiederholt wird.

## Claims

1. Method of NMR (=nuclear magnetic resonance) tomography for generating NMR gradient echo signals according to the principle of signal generation of steady state free precession, wherein a periodic sequence of radio frequency pulses with a flip angle α is applied with time delays TR, wherein successive radio frequency pulses have alternating phases,
**characterized in that**
to largely avoid fluctuating signals from off-resonance spins and moreover generate signals with a higher signal amplitude in the transition to steady state free precession than in steady state free precession itself, the periodic sequence of radio frequency pulses is preceded by a sequence of (n+1) radio frequency pulses, wherein n>1, which generate signals which can be read-out at one reading-out time each, wherein the following conditions apply for the radio frequency pulses:
- a first excitation pulse with a flip angle α₀>α/2 precedes the sequence of radio frequency pulses which are equidistant afterwards;
- the flip angles α₁ to αₙ₋₁ of the subsequent radio frequency pulses are larger than α and are selected such that the transverse magnetization Mtr_{1...n} formed at the respective read-out time is at least almost symmetrical to the magnetization formed at the respectively preceding read-out time with respect to the z-axis, wherein this symmetry continues to the periodic sequence of the radio frequency pulses,
- the flip angles α₁ to αₙ drop substantially monotonically to α;
- the phases of the preceding radio frequency pulses alternate.

2. Method according to claim 1, **characterized in that** with alternating phase, the flip angles α_{1...n} of the radio frequency pulses drop linearly from 180° to α.

3. Method according to any one of the claims 1 or 2, **characterized in that** α₀=90°.

4. Method of NMR (nuclear magnetic resonance) tomography for generating NMR gradient echo signals according to the principle of signal generation of steady state free precession, wherein a periodic sequence of radio frequency pulses with a flip angle α = 180° is applied with time delays TR, wherein successive radio frequency pulses have alternating phases,
**characterized in that**
to largely avoid fluctuating signals from off-resonance spins and moreover generate signals with a higher signal amplitude in the transition to steady state free precession than in steady state free precession itself, the periodic sequence of radio frequency pulses is preceded by a sequence of (n+1) radio frequency pulses, wherein n≥1, for which the following conditions apply:
- a first excitation pulse with a flip angle of 90° precedes the sequence of radio frequency pulses which are equidistant afterwards;
- n-1 radio frequency pulses with a flip angle of 180° are subsequently applied;
- the flip angle of the (n+1)th radio frequency pulse is set to αₙ₊₁ = 90° + α/2;
- the phases of the preceding radio frequency pulses alternate.

5. Method according to any one of the preceding claims, **characterized in that** the time distance between the first excitation pulse and the afterwards equidistant sequence of radio frequency pulses is TR/2.

6. Method according to any one of the preceding claims, **characterized in that** in addition to the sequence of radio frequency pulses, magnetic field gradients are applied for encoding an MR image corresponding to a two- or even multi-dimensional Fourier transformation method such that
- a slice is selected by application of a slice selection gradient during the radio frequency pulses;
- a gradient echo is formed by application of a read gradient which is initially switched on in the sense of a gradient echo method and is then amplitude-reversed,
- phase encoding is performed before reading-out the gradient echo.

7. Method according to claim 6, **characterized in that** phase encoding is effected through application of a phase encoding gradient perpendicularly to the read gradient in the sense of a two-dimensional Fourier transformation method.

8. Method according to claim 6, **characterized in that** phase encoding is effected through application of several phase encoding gradients in directions which are perpendicular to each other for phase encoding in the sense of a multi-dimensional Fourier transformation method.

9. Method according to any one of the preceding claims, **characterized in that** the sequence is preceded by a spin preparation through an inversion pulse for signal weighting with T1.

10. Method according to any one of the preceding claims, **characterized in that** magnetic field gradients are applied corresponding to image encoding in accordance with the method of filtered back projection.

11. Method according to any one of the preceding claims, **characterized in that** after k radio frequency pulses with k>n, a radio frequency pulse with a flip angle 90°+α/2 is initially applied such that the generated magnetization which is in or close to the balanced state (steady state) is transferred into transverse magnetization and is subsequently returned into the steady state through repeating the sequence of radio frequency pulses.

12. Method according to claim 11, **characterized in that** the magnetization is repeatedly returned into transverse magnetization several times.

## Revendications

1. Procédé de tomographie par RMN (= résonance magnétique nucléaire) pour générer des signaux à écho de gradient de RMN selon le principe de la génération de signal de la précession libre en régime stationnaire (*steady state free precession),* dans lequel on utilise une suite périodique d'impulsions à haute fréquence avec un angle de flip α à une distance temporelle TR, des impulsions à haute fréquence consécutives présentant respectivement des phases alternées,
**caractérisé en ce que**,
dans le but d'empêcher le plus possible des signaux fluctuants du spin hors résonance et en outre, lors de la transition vers la précession libre en régime stationnaire, de générer des signaux ayant une amplitude de signal plus grande que dans la précession libre en régime stationnaire proprement dite, on affecte à la suite périodique d'impulsions à haute fréquence une suite de (n+1), avec n>1, impulsions à haute fréquence qui génèrent des signaux qui peuvent être lus chacun à un temps de lecture, les conditions suivantes étant applicables aux impulsions à haute fréquence :
- une première impulsion d'excitation avec un angle de flip α₀ > α/2 est affectée à la suite équidistante suivante des impulsions à haute fréquence ;
- les angles de flip α₁ à αₙ₋₁ des impulsions à haute fréquence suivantes sont plus grands que α et sont choisis de telle façon que la magnétisation transversale Mtr_{1...n} formée à chacun des temps de lecture est au moins pratiquement symétrique par rapport à l'axe z à la magnétisation formée au temps de lecture précédent respectif, cette symétrie continuant jusque dans la suite périodique d'impulsions à haute fréquence ;
- les angles de flip α₁ à αₙ diminuent de manière sensiblement monotone en direction de α ;
- les phases des impulsions à haute fréquence affectées sont alternées.

2. Procédé selon la revendication 1,
**caractérisé en ce que**,
dans le cas d'une phase alternée, les angles de flip α_{1...n} des impulsions à haute fréquence diminuent linéairement de 180° à α.

3. Procédé selon l'une des revendications 1 ou 2,
**caractérisé en ce que**
α₀= 90°.

4. Procédé de tomographie par RMN (= résonance magnétique nucléaire) pour générer des signaux à écho de gradient de RMN selon le principe de la génération de signal de la précession libre en régime stationnaire (*steady state free precession),* dans lequel on utilise une suite périodique d'impulsions à haute fréquence avec un angle de flip α < 180° à une distance temporelle TR, des impulsions à haute fréquence consécutives présentant respectivement des phases alternées,
**caractérisé en ce que**,
dans le but d'empêcher le plus possible des signaux fluctuants du spin hors résonance et en outre, lors de la transition vers la précession libre en régime stationnaire, de générer des signaux ayant une amplitude de signal plus grande que dans la précession libre en régime stationnaire proprement dite, on affecte à la suite périodique d'impulsions à haute fréquence une suite de (n+1), avec n>1, impulsions à haute fréquence qui génèrent des signaux qui peuvent être lus chacun à un temps de lecture, les conditions suivantes étant applicables aux impulsions à haute fréquence :
- une impulsion d'excitation avec un angle de flip de 90° est affectée à la suite équidistante suivante des impulsions à haute fréquence ;
- n-1 impulsions à haute fréquence avec un angle de flip de 180° sont ensuite utilisées ;
- l'angle de flip de la (n+1)^{ième} impulsion à haute fréquence est fixé à αₙ₊₁ = 90° + α/2 ;
- les phases des impulsions à haute fréquence affectées sont alternées.

5. Procédé selon l'une des revendications précédentes,
**caractérisé en ce que**
la distance temporelle entre la première impulsion de sortie et la suite équidistante suivante des impulsions à haute fréquence est égale à TR/2.

6. Procédé selon l'une des revendications précédentes,
**caractérisé en ce que**,
en plus de la suite d'impulsions à haute fréquence, on utilise des gradients de champ magnétique pour coder une image de résonance magnétique suivant une procédure de transformées de Fourier bidimensionnelles ou également pluridimensionnelles et ce de façon à
- sélectionner une couche en utilisant un gradient de sélection de couche pendant les impulsions à haute fréquence,
- former un écho de gradient en utilisant un gradient de lecture qui est tout d'abord activé dans le sens d'un procédé à écho de gradient et dont l'amplitude est ensuite inversée,
- effectuer un codage de phase avant la lecture de l'écho de gradient.

7. Procédé selon la revendication 6,
**caractérisé en ce que**
l'on effectue un codage de phase en utilisant un gradient de codage de phase perpendiculairement au gradient de lecture dans le sens d'une procédure de transformée de Fourier bidimensionnelle.

8. Procédé selon la revendication 6,
**caractérisé en ce que**
l'on effectue un codage de phase en utilisant plusieurs gradients de codage de phase dans des directions perpendiculaires les unes aux autres dans le sens d'une procédure de transformée de Fourier pluridimensionnelle.

9. Procédé selon l'une des revendications précédentes,
**caractérisé en ce qu'**
une impulsion d'inversion est affectée à la séquence d'une préparation de spin pour pondérer le signal avec T1.

10. Procédé selon l'une des revendications précédentes,
**caractérisé en ce que**
l'on effectue une application de gradients de champ magnétique en fonction d'un codage d'image suivant le procédé de la rétroprojection filtrée.

11. Procédé selon l'une des revendications précédentes,
**caractérisé en ce que**,
après k impulsions à haute fréquence avec k>n, on applique tout d'abord une impulsion à haute fréquence avec un angle de flip de 90° + α/2 de façon à convertir la magnétisation formée en magnétisation transversale à ou au voisinage de l'équilibre (= état stationnaire) et ensuite on la ramène à l'équilibre en répétant la suite d'impulsions à haute fréquence.

12. Procédé selon la revendication 11,
**caractérisé en ce que**
la reconversion de la magnétisation en magnétisation transversale est effectuée de manière répétée.
